# FASCICULE DE BREVET EUROPEEN

(11) **EP 1 662 849 B1**
(45) Date de publication et mention de la délivrance du brevet: **29.06.2016**
(21) Numéro de dépôt: 05292453.7
(22) Date de dépôt: 18.11.2005
(51) Int. Cl.: H05K 1/00

(54) **Procédé de fabrication de support de diodes électroluminescentes interconnectées dans un environnement tridimensionnel**
Verfahren zur Herstellung einer verbundenen dreidimensionalen Trägerstruktur für Leuchtdioden
Method for manufacturing a three-dimensional interconnected support for light emitting diodes

(30) Priorité: 22.11.2004 FR 0412390
(43) Date de publication de la demande: 31.05.2006
(73) Titulaire: VALEO VISION, 93012 Bobigny Cedex (FR)
(72) Inventeur: Richard, Stéphane, 93700 Drancy (FR); Nicolai, Jean-Marc, 92400 Courbevoie (FR)

(56) Documents cités:
- DE-A1- 3 404 644
- DE-A1- 19 634 371
- GB-A- 2 061 623
- JP-A- 4 208 588
- US-A1- 2002 068 389
- US-A1- 2003 110 627

## Description

### DOMAINE TECHNIQUE DE L'INVENTION

La présente invention a pour objet un procédé de fabrication de support de diodes électroluminescentes interconnectées dans un environnement tridimensionnel. L'invention a essentiellement pour but de proposer une solution pour positionner, en assurant leur alimentation électrique, plusieurs diodes électroluminescentes appelées leds, sur une surface de maintien qui s'étend sur différents plans de l'espace, en proposant un procédé de fabrication d'un support de ces diodes qui soit facilement industrialisable. En outre, le but de l'invention est atteint en réduisant des coûts de fabrication d'assemblages comparables - dans la mesure où ils réalisent la même fonction au sein d'un dispositif projecteur - de l'état de la technique.

US 2003/110627 divulgue un substrat qui présente deux plans perpendiculaires formant un coin pour y loger un élément de contact de manière à offrir une grande surface d'échange pour évacuer la chaleur.

GB 2 061 623 A divulgue (un circuit imprimé comprenant un circuit principal et des circuits adjacents reliés chacun électriquement au circuit principal par un connecteur.

Le domaine de l'invention est, d'une façon générale, celui de l'éclairage et de la signalisation pour véhicules automobiles. Dans ce domaine, on connaît différents types de dispositifs, parmi lesquels on trouve essentiellement :
- des feux de position, d'intensité et de portée faible ;
- des feux de croisement, ou codes, d'intensité plus forte et de portée sur la route avoisinant 70 mètres ;
- des feux de route longue portée, et des feux de complément de type longue portée, dont la zone de vision sur la route avoisine 200 mètres ;
- des projecteurs perfectionnés, dits bimodes, qui cumulent les fonctions de feux de croisement et de feu de route en incorporant un cache amovible ;
- des feux anti-brouillard ;
- des feux de signalisation ;
- des dispositifs d'éclairage de l'intérieur de l'habitacle ou de compartiments tels que la boîte à gants ou le coffre ....

Pour l'ensemble de ces dispositifs d'éclairage ou de signalisation, traditionnellement, on utilise des sources lumineuses de type lampes halogènes, ou lampes à décharge. Mais depuis quelques années, les équipementiers automobiles ont proposé l'utilisation de diodes électroluminescentes, notamment pour les feux de signalisation, par exemple les feux stop ou les clignotants, ou encore pour les feux anti-brouillard. Les diodes électroluminescentes présentent un certain nombre d'avantages :
- tout d'abord, depuis longtemps, on sait que ce type de diodes ne rayonnent pas de façon omnidirectionnelle, mais rayonnent dans un demi-espace opposé à un substrat qui supporte la jonction P-N de la diode considérée ; ainsi, en utilisant un rayonnement plus directif que les lampes halogènes, ou à décharge, de l'état de la technique, la quantité d'énergie perdue est moins importante qu'avec les lampes à décharge ou halogènes ;
- ensuite, on a récemment perfectionné ces diodes en terme d'intensité de rayonnement ; elles peuvent désormais rayonner un flux d'environ 100 lumens. De plus, les diodes fabriquées émettent un rayonnement depuis longtemps dans le rouge, mais désormais également dans le blanc, ce qui accroît le champ de leurs utilisations envisageables. La quantité de chaleur qu'elles dégagent est relativement limitée, et un certain nombre de contraintes, liées à la dissipation de la chaleur dans les dispositifs projecteurs de l'état de la technique, disparaissent ;
- enfin, les diodes consomment moins d'énergie, même à intensité de rayonnement égal, que les lampes à décharge ou les lampes halogènes ; elles sont peu encombrantes, et leur forme particulière offre des possibilités nouvelles pour la réalisation et la disposition sur des surfaces complexes auxquelles elles sont destinées.

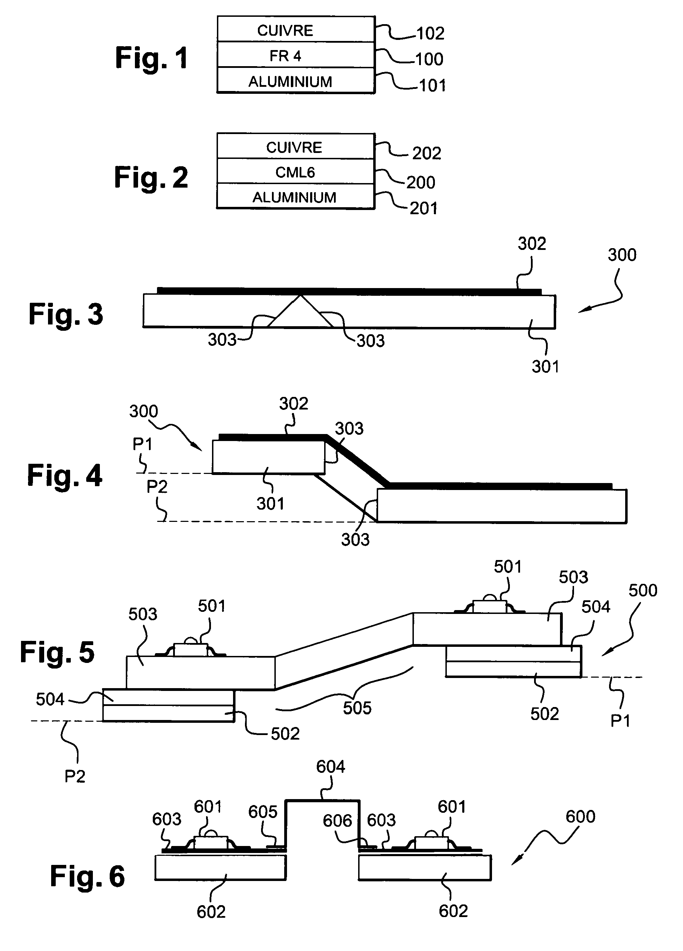

D'une façon générale, les diodes électroluminescentes sont disposées sur un support de type substrat, qui est, selon une définition générale, un matériau destiné à recevoir l'impression d'un circuit électronique, et /ou les différents composants constituant ce circuit. Différents substrats sont fréquemment utilisés dans le domaine automobile pour servir de support aux diodes électroluminescentes. On trouve par exemple :
- les substrats FR4, qui sont des substrats composés d'époxy et de tissus de verre ; de tels substrats entrent dans la majorité des circuits imprimés double face et multicouches;
- les substrats SMI ; on connaît notamment un premier type de substrat SMI, montré à la figure 1, qui est un substrat pour circuit imprimé constitué d'un substrat FR4 100 plaqué sur une semelle métallique 101, par exemple en aluminium, et recouvert d'une couche conductrice de cuivre 102. On connaît également notamment un deuxième type de substrat SMI, montré à la figure 2, qui est un substrat pour circuit imprimé constitué d'un substrat isolant 200 de type CML6 (polymère contenant de la céramique renforcé par une trame de fibre de verre), plaqué sur une semelle métallique 201, par exemple en aluminium, et recouvert d'une couche conductrice de cuivre 202.

De tels substrats, qui ne permettent de réaliser que des circuits imprimés simple face, sont parfaitement appropriés aux applications dissipant de l'énergie, typiquement les dispositifs projecteur de véhicules automobiles ;
- le substrat CEM1, qui est un substrat constitué d'une couche centrale de papier entre deux couches de tissu de verre, très utilisé pour des raisons de faible coût de fabrication.

### ARRIERE-PLAN TECHNOLOGIQUE DE L'INVENTION

De plus en plus, notamment pour répondre à des critères esthétiques exigés par les constructeurs automobiles, on est amené à juxtaposer, au sein d'un même dispositif projecteur, plusieurs diodes électroluminescentes, cette juxtaposition devant souvent se faire en trois dimensions : au sein d'un même dispositif projecteur, différentes leds, éventuellement de différents types, sont disposées sur des plans de maintien différents.

Les solutions existantes pour de telles juxtapositions consistent, dans le cas des leds, essentiellement à utiliser les substrats standards électroniques rigides qui viennent d'être décrits (CEM1, FR4), ou les substrats thermiquement dissipant (SMI, ...), ou éventuellement des substrats électroniques flexibles, appelés flexboards, par exemple réalisés en PEN (polynaphtalate d'éthylène), polyester ou autre...pour recevoir et maintenir les différentes leds et assurer leur interconnexion.

On connaît essentiellement trois solutions dans l'état de la technique pour réaliser des substrats destinés à être placés sur une surface de maintien de forme tridimensionnelle :
Une première solution consiste en l'utilisation d'un substrat souple, permettant la gravure de pistes électriques conductrices ainsi que des empreintes pour la soudure des leds et des composants électroniques les accompagnant. Un tel substrat présente typiquement une épaisseur de 150 micromètres, et peut être aisément plié pour suivre le galbe de la surface de maintien auquel il est destiné. Un tel substrat permet également la brasabilité de composants de types CMS (Composants Montés en Surface). Mais une telle solution pose un gros problème de coût, notamment lorsque les distances entre deux niveaux supportant des leds sont importantes, beaucoup de matière excessivement coûteuse étant alors inutilisée dans la mesure où on n'y dispose pas de diodes.

Une deuxième solution consiste en l'utilisation d'un substrat standard rigide (FR4, CEM1...), solution dans laquelle on dispose une plaque de substrat par plan à occuper pour respecter la forme tridimensionnelle de la surface de maintien imposée par le dispositif projecteur, les différentes plaques de substrat étant reliées par des fils conducteurs pour assurer notamment l'alimentation des leds. Mais une telle solution n'est pas optimisée dans le cadre d'une production industrielle de grande quantité, les fils conducteurs devant être disposés et soudées manuellement.

Une troisième solution consiste en l'utilisation d'inserts métalliques auto-dénudants, qui permettent le maintien mécanique et l'alimentation électrique de la led. Un tel insert est positionné sur un support plastique qui impose que le galbe du support intègre des fils assurant la liaison électrique entre les différentes leds. Mais une telle solution est adaptée uniquement à des leds traversantes, et impose un assemblage manuel.

Toutes les solutions envisagées dans l'état de la technique ne sont donc pas satisfaisantes, que ce soit pour des raisons de coût de fabrication, des raisons de difficulté d'industrialisation du procédé de fabrication, ou encore des raisons de limitation dans les types de leds utilisables.

### DESCRIPTION GENERALE DE L'INVENTION

L'objet de l'invention propose une solution aux problèmes et inconvénients qui viennent d'être exposés. D'une façon générale, l'invention propose d'utiliser des substrats rigides pour servir de support aux diodes électroluminescentes, ces substrats étant moins coûteux que les substrats flexibles. Pour les adapter à l'environnement tridimensionnel auquel ils sont destinés, on propose notamment dans l'invention, de fragiliser, de rendre plus souple, certaines zones d'une couche inférieure du substrat utilisé, afin de pouvoir déformer le substrat au niveau de ces zones assouplies, la déformation ayant alors lieu sans entraîner de rupture dans la conduction électrique d'une couche supérieure du substrat, couche supérieure sur laquelle sont disposées les diodes. On offre ainsi des possibilités de pliage à partir d'un substrat rigide. Dans un autre mode de mise en oeuvre de l'invention, on propose de réaliser autant de plaques de substrat rigide qu'il existe de plans de maintien dans l'environnement tridimensionnel, et de relier ces différentes plaques de substrat au moyen de composants conducteurs déformable disposés selon une technologie CMS (Composants Montés en Surface).

L'invention concerne donc essentiellement un procédé de fabrication de support de diodes électroluminescentes, de type substrat rigide constitué au moins d'une couche inférieure réalisée dans un premier matériau et d'une couche supérieure réalisée dans un deuxième matériau électriquement conducteur, ledit support étant destiné à positionner plusieurs diodes électroluminescentes sur au moins deux plans de maintien distincts au sein d'un dispositif projecteur pour véhicule automobile, caractérisé en ce qu'il comporte les différentes étapes consistant à :
- assouplir des secteurs de la couche inférieure réalisée dans le premier matériau pour la rendre déformable sans provoquer de rupture de la couche supérieure ;
- disposer les diodes électroluminescentes sur la couche supérieure;
- disposer le support de diodes électroluminescentes selon les différents plans de maintien, au moins un changement de niveau entre deux plans de maintien successifs étant assuré par la présence d'au moins un secteur assoupli, à l'endroit du changement de niveau, de la couche inférieure pour rendre possible la déformation du support de diodes électroluminescentes.

Dans un premier exemple de mise en oeuvre du procédé selon l'invention, l'étape d'assouplissement de secteurs de la couche inférieure consiste à rainurer, à l'endroit des secteurs à assouplir, une couche d'aluminium constituant la couche inférieure du substrat, ledit substrat étant du type SMI.

Dans un deuxième exemple de mise en oeuvre du procédé selon l'invention, l'étape d'assouplissement de secteurs de la couche inférieure consiste à rainurer, à l'endroit des secteurs à assouplir, une couche de fibre de verre constituant la couche inférieure du substrat, ledit substrat étant du type FR4.

Dans un troisième exemple de réalisation de l'invention, l'étape d'assouplissement de secteurs de la couche inférieure consiste à supprimer, à l'endroit des secteurs à assouplir, une couche d'aluminium constituant la couche inférieure du substrat, ledit substrat étant du type SMI.

Dans une variante du troisième exemple de mise en oeuvre, l'étape d'assouplissement de secteurs de la couche inférieure consiste à supprimer, à l'endroit des secteurs à assouplir, en plus de la couche d'aluminium constituant la couche inférieure du substrat, une couche intermédiaire de matériau thermiquement isolant.

Dans une variante du troisième exemple de mise en oeuvre, le procédé selon l'invention comporte l'étape supplémentaire préalable consistant à réduire, à l'endroit des secteurs à assouplir, lors de la fabrication du substrat de type SMI, l'adhérence entre deux couches adjacentes constituant ledit substrat.

La présente invention se rapporte également à un procédé de fabrication de support de diodes électroluminescentes, ledit support étant constitué d'une pluralité de plaques de substrat rigide, chaque plaque de substrat étant constituée au moins d'une couche inférieure réalisée dans un premier matériau et d'une couche supérieure réalisée dans un deuxième matériau électriquement conducteur, ledit support étant destiné à positionner plusieurs diodes électroluminescentes sur au moins deux plans de maintien distincts au sein d'un dispositif projecteur à équiper pour véhicule automobile, caractérisé en ce qu'il comporte les différentes étapes consistant à :
- réaliser autant de plaques de substrat constituant le support qu'il existe de plans de maintien distincts dans le dispositif projecteur à équiper ;
- relier au moins deux plaques de substrat distinctes au moyen d'un composant spécifique électriquement conducteur permettant une déformation selon trois axes, ledit composant spécifique étant soudé par une opération de brasage par refusion ou de barre chaude sur les différentes plaques de substrat qu'il relie ;
- disposer le support de diodes électroluminescentes selon les différents plans de maintien, un changement de niveau entre deux plans de maintien successifs étant assuré par une déformation du composant spécifique.

En variante à tous ces exemples de mise en oeuvre, on pourra prévoir que le substrat comporte en outre entre les couches inférieure et supérieure une couche intermédiaire de matériau isolant électriquement.

L'invention et ses différentes applications seront mieux comprises à la lecture de la description qui suit et à l'examen des figures qui l'accompagnent.

### BREVE DESCRIPTION DES FIGURES

Celles-ci ne sont présentées qu'à titre indicatif et nullement limitatif de l'invention. Les figures montrent :
- à la figure 1, déjà décrite, une représentation schématique d'un premier exemple de substrat SMI ;
- à la figure 2, également déjà décrite, une représentation schématique d'un deuxième exemple de substrat SMI ;
- à la figure 3 et à la figure 4, une illustration d'un premier exemple et d'un deuxième exemple de mise en oeuvre du procédé selon l'invention ;
- à la figure 5, une illustration d'un troisième exemple de mise en oeuvre du procédé selon l'invention ;
- à la figure 6, une illustration d'un quatrième exemple de mise en oeuvre du procédé selon l'invention.

### DESCRIPTION DES FORMES DE RÉALISATION PRÉFÉRÉES DE L'INVENTION

Les différents éléments apparaissant sur plusieurs figures auront gardé, sauf précision contraire, la même référence.

A la figure 3 et à la figure 4, on a représenté de façon schématique un support 300 de diodes électroluminescentes intervenant dans deux exemples de mise en oeuvre du procédé selon l'invention. Le support 300 est un substrat rigide, soit de type SMI, soit de type FR4. Dans tous les cas, il est constitué au moins d'une couche inférieure 301 et d'une couche supérieure 302, ladite couche supérieure étant une couche de cuivre relativement épaisse permettant d'assurer une continuité électrique entre les différentes diodes électroluminescentes qui y seront disposées. Lorsque le substrat 300 est du type SMI, la couche inférieure est en aluminium ; lorsque le substrat 300 est du type FR4, la couche inférieure est une couche de fibre de verre.

Selon le procédé de l'invention, on propose d'assouplir le substrat 300 en intervenant sur la couche inférieure 301 de telle sorte que le substrat 300 puisse se plier, pour épouser, lors de l'assemblage mécanique dans le dispositif projecteur, des plans de maintien distincts au sein du dispositif projecteur auquel il est destiné ; à cet effet, on prévoit par exemple de réaliser des rainures, des entailles, 303 uniquement dans la couche inférieure, aux endroits où le substrat doit présenter un changement de niveau, pour passer d'un premier plan à un second plan de maintien. D'une structure de substrat plane montrée à la figure 3, on peut alors aboutir à une structure courbe montrée à la figure 4, où le substrat 300 peut être disposé sur deux plans de maintien distincts P1 et P2 sans provoquer de rupture au niveau de la couche supérieure conductrice 302.

En variante, on pourra prévoir de disposer, entre la couche inférieure 301 et la couche supérieure 302, une couche intermédiaire de matériau électriquement isolant.

A la figure 5, on a représenté de façon schématique un support 500 de diodes électroluminescentes 501 intervenant dans un troisième exemple de mise en oeuvre du procédé selon l'invention. Le support 500 est, dans cet exemple de mise en oeuvre, un substrat rigide de type SMI. Il est, encore une fois, constitué au moins d'une couche inférieure 502 et d'une couche supérieure 503, ladite couche supérieure étant une couche de cuivre plus épaisse que dans les exemples précédents, typiquement 210 micromètres. Entre la couche supérieure 503 et la couche inférieure 502 se trouve une couche intermédiaire 504 en matériau thermiquement isolant.

Selon le procédé de l'invention, on propose d'assouplir le substrat 500 en supprimant la couche inférieure 502 dans certaines zones 505, dites zones de transition, de telle sorte que le substrat 500 puisse facilement se plier, pour épouser, lors de l'assemblage mécanique dans le dispositif projecteur, des plans de maintien distincts au sein du dispositif projecteur auquel il est destiné ; dans un exemple de mise en oeuvre, les zones de transition 505 sont celles au-dessus desquelles la couche supérieure ne supportera pas de diodes électroluminescentes. Les zones de transition sont ainsi privilégiées pour effectuer un pliage du substrat 500 pour que ce dernier passe, par exemple, du premier plan de maintien P1 au deuxième plan de maintien P2.

Dans une variante du troisième mode de mise en oeuvre du procédé selon l'invention, on supprime, au niveau des zones de transition 505, également la couche intermédiaire 504 en matériau électriquement isolant. La suppression de la couche inférieure 502, et éventuellement de la couche intermédiaire 504 peut, dans un exemple de mise en oeuvre, être facilitée par une opération préliminaire lors de la fabrication du substrat 500, opération préliminaire au cours de laquelle l'adhérence entre les différentes couches constituant le substrat est volontairement réduite au niveau des zones de transition.

La suppression de la couche d'aluminium 502 dans les zones de transition permet par ailleurs de réaliser une fonction connectique, entre des connecteurs du dispositif projecteur et des pistes conductrices imprimées sur la couche supérieure 503, de type connecteur encartable (card-edge dans la littérature anglaise); dans une telle fonction connectique, on prévoit au moins connecteur dans lequel la tranche d'une carte imprimée, ici le substrat 500 débarrassé de la couche d'aluminium 502, est insérée afin d'assurer le contact directement avec les contacts imprimés sur le bord de ladite carte. Cette fonction connectique est économiquement particulièrement intéressante.

A la figure 6, on a représenté de façon schématique un support 600 de diodes électroluminescentes 601 intervenant dans un quatrième exemple de mise en oeuvre du procédé selon l'invention. Le support 600 est constitué, dans cet exemple, d'autant de plaques de substrat 602 rigide standard (de type CEM1, SMI, FR4...) qu'il existe de plans de maintien distincts des diodes au sein du dispositif projecteur à équiper.

Dans cet exemple de mise en oeuvre, les différentes plaques de substrat 602 sont reliées entre elles au moyen d'un composant spécifique 604 électriquement conducteur, présentant une première extrémité 605 et une seconde extrémité 606 ; chacune des extrémités est en contact avec une couche supérieure 603 d'une des plaques de substrat 602, électriquement conductrice, typiquement une couche de cuivre, qui supporte également les diodes électroluminescentes 601. Le composant spécifique 604, d'une part assure la liaison électrique entre deux plaques de substrat distinctes 602, et d'autre part permet un déplacement dans les trois axes de l'espace d'une première plaque de substrat par rapport à une autre plaque de substrat qu'il relie.

Dans un mode de mise en oeuvre avantageux, le composant spécifique 604 est un composant utilisé en technologie CMS (pour Composant Monté en Surface, ou Composant pour Montage en Surface). Cette technologie consiste à souder des composants sur un substrat à sa surface, plutôt que d'en faire passer les pattes à travers. L'opération de soudage du composant spécifique 604 est réalisé au cours d'une opération de brasage par refusion, opération dans laquelle on dépose de la pâte à braser aux endroits appropriés de la couche supérieure 603.

On pourra également prévoir de disposer, entre la couche supérieure 603 et la plaque de substrat 602 une couche intermédiaire de matériau électriquement isolant.

Parmi les diodes électroluminescentes qui peuvent être montées sur les supports fabriqués selon le procédé de l'invention, on peut citer par exemple celles qui sont connues par l'homme du métier sous les noms commerciaux de smartled, power topled, advance power topled, dragon led, piranha, luxeon...(marques déposées)

## Revendications

1. Procédé de fabrication de support (300 ; 500) de diodes électroluminescentes, de type substrat rigide constitué au moins d'une couche inférieure (301 ; 501) réalisée dans un premier matériau et d'une couche supérieure (302 ; 503) réalisée dans un deuxième matériau électriquement conducteur, ledit support étant destiné à positionner plusieurs diodes électroluminescentes (501) sur au moins deux plans de maintien (P1 ; P2) distincts au sein d'un dispositif projecteur pour véhicule automobile, **caractérisé en ce qu**'il comporte les différentes étapes consistant à :
- assouplir des secteurs (303) de la couche inférieure réalisée dans le premier matériau pour la rendre déformable sans provoquer de rupture de la couche supérieure ;
- disposer les diodes électroluminescentes sur la couche supérieure;
- disposer le support de diodes électroluminescentes selon les différents plans de maintien, au moins un changement de niveau entre deux plans de maintien successifs étant assuré par la présence d'au moins un secteur assoupli, à l'endroit du changement de niveau, de la couche inférieure pour rendre possible la déformation du support de diodes électroluminescentes.

2. Procédé selon la revendication précédente, **caractérisé en ce que** l'étape d'assouplissement de secteurs de la couche inférieure consiste à rainurer, à l'endroit des secteurs à assouplir, une couche d'aluminium constituant la couche inférieure du substrat, ledit substrat étant du type SMI.

3. Procédé selon la revendication 1, **caractérisé en ce que** l'étape d'assouplissement de secteurs de la couche inférieure consiste à rainurer, à l'endroit des secteurs à assouplir, une couche de fibre de verre constituant la couche inférieure du substrat, ledit substrat étant du type FR4.

4. Procédé selon la revendication 1, **caractérisé en ce que** l'étape d'assouplissement de secteurs de la couche inférieure consiste à supprimer, à l'endroit des secteurs à assoupir, une couche d'aluminium constituant la couche inférieure du substrat, ledit substrat étant du type SMI.

5. Procédé selon la revendication précédente, **caractérisé en ce que** l'étape d'assouplissement de secteurs de la couche inférieure consiste à supprimer, à l'endroit des secteurs à assouplir, en plus de la couche d'aluminium constituant la couche inférieure du substrat, une couche intermédiaire (504) de matériau électriquement isolant.

6. Procédé selon l'une des revendications 4 ou 5 **caractérisé en ce qu'**il comporte l'étape supplémentaire préalable consistant à réduire, à l'endroit des secteurs à assouplir, lors de la fabrication du substrat de type SMI, l'adhérence entre deux couches adjacentes constituant ledit substrat.

## Patentansprüche

1. Verfahren zum Herstellen eines Trägers (300; 500) für Leuchtdioden vom Typ starres Substrat, das wenigstens aus einer aus einem ersten Material ausgeführten unteren Schicht (301; 501) und einer aus einem elektrisch leitenden zweiten Material ausgeführten oberen Schicht (302; 503) besteht, wobei der Träger dazu bestimmt ist, mehrere Leuchtdioden (501) auf wenigstens zwei separaten Halteebenen (P1; P2) innerhalb einer Kraftfahrzeugscheinwerfervorrichtung zu positionieren, **dadurch gekennzeichnet, dass** es die folgenden verschiedenen Schritte umfasst:
- Nachgiebig machen der Bereiche (303) der aus dem ersten Material ausgeführten unteren Schicht, um diese verformbar zu machen, ohne ein Brechen der oberen Schicht zu bewirken;
- Anordnen der Leuchtdioden auf der oberen Schicht;
- Anordnen des Leuchtdiodenträgers in den verschiedenen Halteebenen, wobei ein Höhenunterschied zwischen zwei aufeinanderfolgenden Halteebenen dadurch gewährleistet ist, dass es an der Stelle des Höhenunterschieds wenigstens einen nachgiebigen Bereich der unteren Schicht gibt, um die Verformung des Leuchtdiodenträgers zu ermöglichen.

2. Verfahren nach dem vorhergehenden Anspruch,
**dadurch gekennzeichnet, dass** der Schritt des Nachgiebig machens von Bereichen der unteren Schicht darin besteht, am Ort der nachgiebig zu machenden Bereiche eine die untere Schicht des Substrats bildende Aluminiumschicht mit Rillen zu versehen, wobei das Substrat vom Typ IMS ist.

3. Verfahren nach Anspruch 1,
**dadurch gekennzeichnet, dass** der Schritt des Nachgiebig machens von Bereichen der unteren Schicht darin besteht, am Ort der nachgiebig zu machenden Bereiche eine die untere Schicht des Substrats bildende Glasfaserschicht mit Rillen zu versehen, wobei das Substrat vom Typ FR4 ist.

4. Verfahren nach Anspruch 1,
**dadurch gekennzeichnet, dass** der Schritt des Nachgiebig machens von Bereichen der unteren Schicht darin besteht, am Ort der nachgiebig zu machenden Bereiche eine die untere Schicht des Substrats bildende Aluminiumschicht zu entfernen, wobei das Substrat vom Typ IMS ist.

5. Verfahren nach dem vorhergehenden Anspruch,
**dadurch gekennzeichnet, dass** der Schritt des Nachgiebig machens von Bereichen der unteren Schicht darin besteht, am Ort der nachgiebig zu machenden Bereiche zusätzlich zu der die untere Schicht des Substrats bildenden Aluminiumschicht eine Zwischenschicht (504) aus elektrisch isolierendem Material zu entfernen.

6. Verfahren nach einem der Ansprüche 4 oder 5,
**dadurch gekennzeichnet, dass** es vorab den zusätzlichen Schritt umfasst, bei der Herstellung des Substrats vom Typ IMS am Ort der nachgiebig zu machenden Bereiche das Haftvermögen zwischen zwei das Substrat bildenden benachbarten Schichten zu verringern.

## Claims

1. Method for production of a light-emitting diode support (300; 500), of the rigid substrate type constituted by at least a lower layer (301; 501) made of a first material and an upper layer (302; 503) made of a second, electrically conductive material, the said support being designed to position a plurality of light-emitting diodes (501) on at least two distinct retention planes (P1; P2) within a headlight device for a motor vehicle, **characterised in that** it comprises the different steps consisting of:
- making sectors (303) of the lower layer which are made of the first material flexible, in order to make the layer deformable without giving rise to rupture of the upper layer;
- arranging the light emitting diodes on the upper layer;
- arranging the light-emitting diode support according to the different retention planes, at least one change of level between two successive retention planes being ensured by the presence of at least one sector made flexible, at the location of the change of level, of the lower layer, in order to make possible the deformation of the light-emitting diode support.

2. Method according to the preceding claim, **characterised in that** the step of making sectors of the lower layer flexible, consists of channelling, in the location of the sectors to be made flexible, an aluminium layer constituting the lower layer of the substrate, the said substrate being of the SMI type.

3. Method according to claim 1, **characterised in that** the step of making sectors of the lower layer flexible consists of channelling, in the location of the sectors to be made flexible, a glass fibre layer constituting the lower layer of the substrate, the said substrate being of the FR4 type.

4. Method according to claim 1, **characterised in that** the step of making sectors of the lower layer flexible consists of eliminating, in the location of the sectors to be made flexible, an aluminium layer constituting the lower layer of the substrate, the said substrate being of the SMI type.

5. Method according to the preceding claim, **characterised in that** the step of making sectors of the lower layer flexible consists of eliminating, in the location of the sectors to be made flexible, in addition to the aluminium layer constituting the lower layer of the substrate, an intermediate layer (504) of electrically insulating material.

6. Method according to one of claims 4 or 5, **characterised in that** it comprises the prior additional step consisting of reducing, in the location of the sectors to be made flexible, during the production of the substrate of the SMI type, the adhesion between two adjacent layers which constitute the said substrate.
